# EUROPÄISCHE PATENTANMELDUNG

(11) **EP 0 522 183 A1**
(43) Veröffentlichungstag der Anmeldung: **13.01.1993**
(21) Anmeldenummer: 91110765.4
(22) Anmeldetag: 28.06.1991
(51) Int. Cl.: F16H 57/02

(54) **In einer Gehäusewand randseitig wasserdicht gehaltenes Druckausgleichselement**

(71) Anmelder: SIEMENS AKTIENGESELLSCHAFT, D-80333 München (DE)
(72) Erfinder: Luckas, Thomas, Dipl.-Ing. (FH), W-8723 Gerolzhofen (DE)

(57) **Zusammenfassung**

Zur einfachen wasserdichten Halterung eines Druckausgleichselementes mit in einem Membranträger (3) aufgenommener PTFE-Membran (4) in einer Gehäusewandöffnung (11), z.B. eines Getriebegehäuses (1), ist erfindungsgemäß ein Membranträger (3) mit daran vormontiert gehaltenem, außen umlaufenden gesonderten O-Ring (5) als Dichtmittel vorgesehen, mittels dessen der Membranträger (3) in seiner Betriebsendlage in der Gehäusewandöffnung (11) im Quetschsitz arretierbar ist.

## Beschreibung

Die Erfindung bezieht sich auf ein in einer Gehäusewand randseitig wasserdicht gehaltenes Druckausgleichselement gemäß Oberbegriff des Anspruchs 1; ein derartiges Druckausgleichselement ist aus der DE-U-89 11 042 bekannt.

Im bekannten Fall ist ein in eine Gehäusewandöffnung eines Getriebegehäuses eines Fensterheberantriebes eingesetztes Druckausgleichselement vorgesehen, das einen Sicherungsring enthält, der als Halter für die an diesem vormontierbare PTFE-Folie ausgebildet und randseitig mit zumindest einer umlaufenden elastischen Dichtlippe ausgebildet ist, durch welche der Sicherungsring mit der vormontierten PTFE-Folie nach dem Einstecken in die Gehäusewandöffnung in dieser wasserdicht verkrallbar ist.

Bei einem durch die DE-U-87 07 254 bekannten Druckausgleichselement wird zur Fixierung einer PTFE-Membran in einer Gehäuseeinsenkung eines Getriebegehäuses eines Kraftfahrzeug-Fensterhebers die Membran von außen bis zu einer Abstützschulter der Gehäuseeinsenkung eingesteckt und in Gegenrichtung nach Zwischenlage eines gesonderten Dichtringes durch eine gegengedrückte, in ihrer Endlage in der Gehäuseeinsenkung verkrallbare Federscheibe fixiert; dazu ist die Federscheibe tellerförmig mit durchbrochenem und in den Teller hineingewölbtem Tellerboden versehen.

Ein gegenüber den bekannten Lösungen mit geringerem Montage- und Bauteileaufwand in einer Gehäuseeinsenkung fixierbares und auch bei hohen Temperaturbelastungen eine sichere randseitige Feuchtigkeitsabdichtung gewährleistendes Druckausgleichselement ist erfindungsgemäß durch die Lehre des Anspruchs 1 möglich; vorteilhafte Ausgestaltungen der Erfindung sind jeweils Gegenstand der Unteransprüche.

Durch die erfindungsgemäße Konstruktion kann in einem Arbeitsgang durch das Einschieben eines einzigen vormontierbaren Membranträger, Membrane und gesondertes Dichtteil umfassenden Kombinationsbauteils in die Gehäusewandöffnung einerseits eine Fixierung der Membran in ihrer Betriebsendlage erreicht und andererseits eine randseitige Wasserdichtheit gewährtleistet werden, wobei durch die Möglichkeit unterschiedlicher Materialwahl für den Membranträger einerseits und das Dichtteil andererseits den spezifischen Anforderungen der Halterung bzw. der Dichtung individuell bestmöglichst entsprochen werden kann.

Zweckmäßigerweise ist als Dichtring ein sogenannter O-Ring vorgesehen, der zur Vormontage nach einer ersten vorteilhaften Ausgestaltung der Erfindung, insbesondere bei einer Herstellung aus Gummi, in eine randseitig umlaufende Nut des Membranträgers mit radialem Überstand und unter Vorspannung vormontiert eingelegt oder nach einer weiteren vorteilhaften Ausgestaltung, insbesondere bei Herstellung aus einem elastischen Thermoplast und einem Kunststoff-Membranträger, in einen umlaufenden Außenrand des Membranträgers mit radialem Überstand eingespritzt ist.

Es hat sich in überraschender Weise gezeigt, daß in der Regel der Membranträger allein aufgrund des radialen Übermaßes des Dichtringes relativ zum Außendurchmesser des Membranträgers bzw. zur lichten Weite der Gehäuseöffnung durch einen Quetschsitz des Dichtringes in seiner Endlage in der Gehäusewandöffnung fixierbar ist. Bei besonders starken Stoß- und/oder Wärmebelastungen oder zur Vormontagehalterung in der Gehäusewandöffnung kann nach einer weiteren Ausgestaltung der Erfindung vorgesehen werden, daß der Membranträger zusätzlich mittels randseitig angeformter Sperrelemente an der Gehäusewand der Gehäusewandöffnung verkrallbar ist.

Die Erfindung sowie weitere vorteilhafte Ausgestaltungen der Erfindung gemäß Merkmalen der Unteransprüche werden im folgenden anhand eines schematisch dargestellen Ausführungsbeispiels in der Zeichnung näher erläutert; darin zeigen:
- FIG 1: in einem axialen Teilschnittbild einen Fensterheber-Antrieb für ein Kraftfahrzeug mit im Getriebegehäuse angeordnetem Druckausgleichselement,
- FIG 2: eine stirnseitige Draufsicht auf ein erfindungsgemäßes Druckausgleichselement,
- FIG 3: eine Seitenansicht des Druckausgleichselementes gemäß FIG 2,
- FIG 4: einen Teilschnitt des in eine Gehäusewandöffnung eingesteckten Druckausgleichselementes gemäß Schnittverlauf IV-IV in FIG 1.

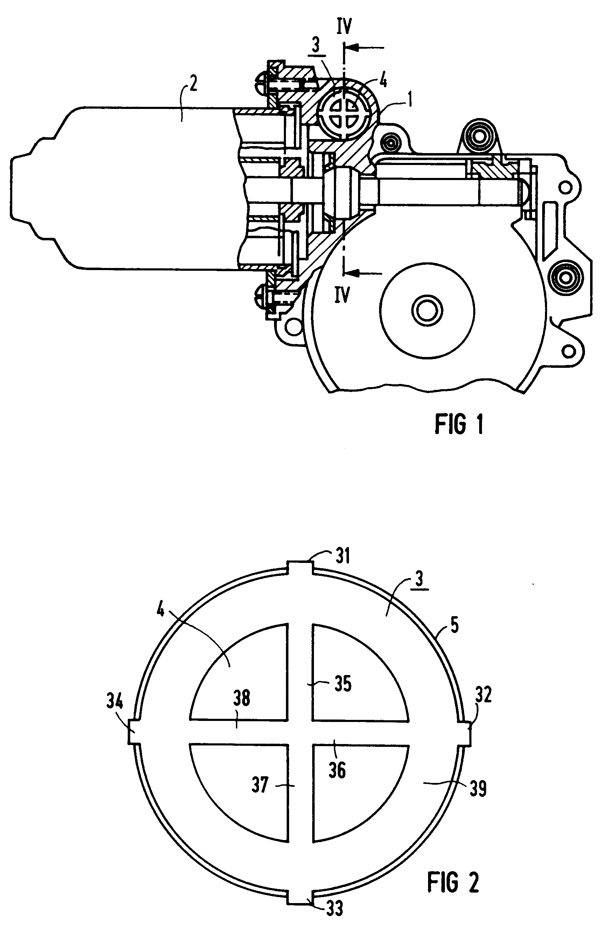

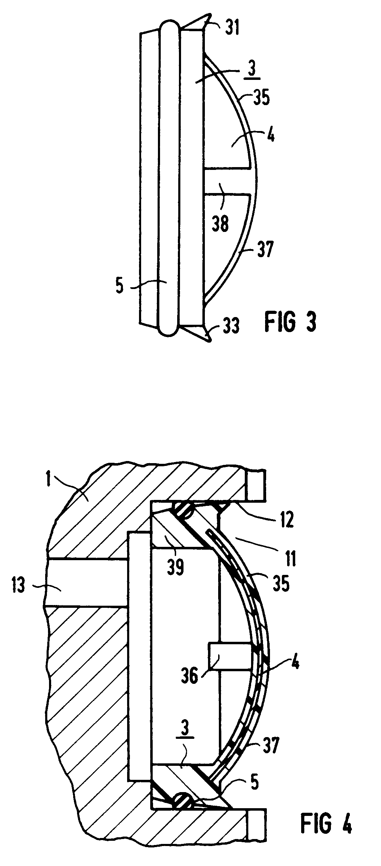

FIG 1 zeigt einen Fensterheber-Antrieb für ein Kraftfahrzeug mit einem ein Schneckengetriebe aufnehmenden Getriebegehäuse 1 und einem daran angeschraubten Motorgehäuse 2 eines mit einer Schneckenwelle in das Getriebegehäuse 1 ragenden antreibenden Kommutatormotors. Das Getriebegehäuse 1 weist eine aus FIG 4 näher ersichtliche Gehäusewandöffnung 11 auf, die durch ein Druckausgleichselement mit einer PTFE-Membran 4 derart verschlossen ist, daß ein Gasaustausch durch die PTFE-Membran zwar stattfinden kann, jedoch das Eindringen von Feuchtigkeit in das Getriebegehäuse 1 mit Sicherheit vermeidbar ist; zu diesem Zweck muß die PTFE-Membran zusätzlich randseitig wasserdicht in der Gehäusewandöffnung 11 gehalten sein.

FIG 2 bis 4 zeigen in Drauf- bzw. Seitenansicht und im Schnitt im einzelnen den Aufbau eines erfindungsgemäßen Druckausgleichselement, das in die Gehäusewandöffnung 11 des Getriebegehäuses 1 einsetzbar ist, wobei die Gehäusewandöffnung 11 über eine Durchführungsöffnung 13 mit dem Inneren des Getriebegehäuses 1 verbunden ist.

FIG 3,4 zeigen das erfindungsgemäße Druckausgleichselement als vormontiertes Kombinationsbauteil, bestehend aus einem Membranträger 3, einem daran vormontiert gehaltenen umlaufenden, radial überstehenden Dichtmittel in Form eines O-Ringes 5 und einer in den Membranträger 3 eingeschweißten PTFE-Membran 4.

Zum Schutz und gleichzeitig einfachen Lagefixierung der leicht gewölbten PTFE-Membran 4 weist der Membranträger 3 außer einem umlaufenden Außenrand 39 vier davon radial ausgehende kreuzweise angeordnete Schutzstreben 35-38 auf. Der im Ausführungsbeispiel zweckmäßigerweise aus Gummimaterial gebildete O-Ring 5 ist mit Vorspannung in eine umlaufende Nut des Membranträgers 3 derart vormontiert eingelegt, daß der Membranträger 3 mit dem O-Ring 5 als Kombinationsbauteil in die Gehäusewandöffnung 11, vorteilhafterweise durch einen Handhabungsautomaten, einsteckbar ist und dabei der O-Ring 5, wie insbesondere aus FIG 4 ersichtlich, durch Quetschung an der Gehäusewand 12 der Gehäusewandöffnung 11 sowohl der Fixierung des Membranträgers in seiner Betriebsendlage als auch seiner dichtenden Anlage an der Gehäusewand 12 dient.

Zur zusätzlichen Sicherung des Membranträgers 3 in seiner Betriebsendlage bei besonders starker mechanischer, insbesondere stoßartiger, Belastung sind am Umfang des Membranträgers 3 in Verlängerung der Schutzstreben 35-38 am Außenumfang Krallhaken 31-34 vorgesehen, die entgegen der Einsteckrichtung des Membranträgers 3 in die Gehäuseöffnung 11 schräggestellt sind. Dadurch daß der Außendurchmesser der Krallhaken 31-34 ebenso wie der des Dichtringes 5 im unmontierten Zustand des Membranträgers 3 größer sind als der Innendurchmesser der Gehäusewandöffnung 11, ist gewährleistet, daß neben der Abdichtung zwischen dem O-Ring 5 und der Gehäusewand 12 der Gehäusewandöffnung 11 auch eine kraft- und aufgrund der Rauhigkeit der Gehäusewand 12 gegebenenfalls auch eine formschlüssige Fixierung der Betriebsendlage des Membranträgers 3 gewährleistet werden kann.

## Patentansprüche

1. In einer Gehäusewandöffnung (11) randseitig wasserdicht gehaltenes Druckausgleichselement (3;4) mit einer gasdurchlässigen, jedoch das Eindringen von Wasser in das Gehäuse (Getriebegehäuse 1) verhindernden Membran (4), die in einem Membranträger (3) aufgenommen ist, der mit einem randseitig umlaufenden Dichtteil in seiner Endlage wasserdicht gegen die Gehäusewand (12) der Gehäusewandöffnung (11) gedrückt ist, **dadurch gekennzeichnet,** daß als Dichtteil ein gesonderter Dichtring (O-Ring 5) vormontiert am Membranträger (3) gehalten ist.

2. Druckausgleichselement nach Anspruch 1, **dadurch gekennzeichnet,** daß als Dichtring ein O-Ring (5) vorgesehen ist.

3. Druckausgleichselement nach Anspruch 1 oder 2, **dadurch gekennzeichnet,** daß der Dichtring (5) in eine randseitig umlaufende Nut des Membranträgers (3) mit radialem Überstand vormontiert eingelegt ist.

4. Druckausgleichselement mit einem Kunststoff-Membranträger nach Anspruch 1 oder 2, **dadurch gekennzeichnet,** daß der Dichtring (5) in einen umlaufenden Außenrand des Membranträgers (3) mit radialem Überstand eingespritzt ist.

5. Druckausgleichselement nach Anspruch 4, **dadurch gekennzeichnet,** daß der Dichtring (5) aus einem elastischen Thermoplast besteht.

6. Druckausgleichselement nach einem der Ansprüche 1-5, **dadurch gekennzeichnet,** daß der Membranträger (3) mittels des Dichtringes (5) im Quetschsitz in seiner Endlage in der Gehäusewandungsöffnung (11) fixiert ist.

7. Druckausgleichselement nach einem der Ansprüche 1-6, **gekennzeichnet durch** randseitig an den Membranträger (3) angeformte, in der Gehäusewand (12) der Gehäusewandöffnung (11) verkrallbare Sperrelemente (Krallhaken 31-34).

8. Druckausgleichselement nach Anspruch 7, **dadurch gekennzeichnet,** daß die Krallhaken (31-34) des unmontierten Membranträgers (3) entgegen ihrer Einsteckrichtung in die Gehäusewandöffnung (11) schräggestellt sind.

9. Druckausgleichselement nach einem der Ansprüche 1-8, **dadurch gekennzeichnet,** daß der Außendurchmesser des Dichtringes (5) und/oder der Sperrelemente (Krallhaken 31-34) des unmontierten Membranträgers (3) größer ist als der Innendurchmesser der Gehäusewandöffnung (11).
